Europäisches Patentamt

European Patent Office

Office européen des brevets

(11) Publication number: **0 166 563**
A2

(12) **EUROPEAN PATENT APPLICATION**

(21) Application number: **85304317.2**

(22) Date of filing: **17.06.85**

(51) Int. Cl.⁴: **H 03 H 17/06**

(30) Priority: **21.06.84 US 622911**

(43) Date of publication of application: **02.01.86**
Bulletin **86/1**

(84) Designated Contracting States: **DE FR GB**

(71) Applicant: **TEXAS INSTRUMENTS INCORPORATED,**
**13500 North Central Expressway, Dallas**
**Texas 75265 (US)**

(72) Inventor: **Hinman, Karl Ellis, 2133 Eldorado Way,**
**Carrollton, TX 75006 (US)**
Inventor: **Langston, J. Leland, 6041 Village Bend, 2407,**
**Dallas, TX 75206 (US)**

(74) Representative: **Abbott, David John et al, Abel & Imray**
**Northumberland House 303-306 High Holborn, London,**
**WC1V 7LH (GB)**

(54) **Residue number system universal digital filter.**

(57) A residue number system (RNS) universal digital filter (20) is disclosed. The filter system includes an A/D converter (22) for digitizing the analog input signals into binary coded signals, a decomposition means (24) for converting the binary coded signals into an RNS format, a filter (26) for filtering the input signal in the RNS format, a recomposition means (30) for converting the output from the RNS format back to a binary format and a D/A converter (32) for converting the binary coded output signal to an analog signal.

1

# RESIDUE NUMBER SYSTEM UNIVERSAL DIGITAL FILTER

This invention relates to digital filters and more particularly to a residue number system (RNS) implemented finite impulse response (FIR) digital filter.

The term digital filter is used to define a discrete-time, discrete-amplitude convolution process. The input signals are discrete-time sequences as a consequence of the analog signals being sampled at discrete points in time. The signal samples are then converted to digital numbers by an analog to digital (A/D) converter. The A/D converter has a finite number of states which can be used to represent the amplitude of the input signal. Thus, the output of the A/D converter is a set of discrete amplitude values represented by a range of integer number values. The range of the digital representation of the signal is given by:

$N=2^m$ where m=number of bits in A/D output word. The number of bits could theoretically be made arbitrarily large. Practical A/D converters, however, are limited to 8 to 16 bits of accuracy. The output from the A/D converter is therefore a discrete-time sequence of m-bit data words, $X(n)$.

The digital convolution of a filter function having an impulse response represented by a sequence, $h(n)$ with the input sequence, $X(n)$, is given by:

$$y(n)= \sum_{k=0}^{N-1} h(k)X(n-k)$$

for a finite number of input samples, N. Because the impulse response is represented by a finite number of samples, this type of filter is called a finite impulse response (FIR) filter.

In the past the convolution function has been implemented directly using a microprocessor. The input sequence, $X(n)$, has a word width of p bits while each filter coefficient, $h(k)$ has a word width of q bits. Hence, the

2

memory word used to implement the delay function is p bits wide, a multiplier multiplies p x q with an output width of p + q, and the convolution sum is implemented using an accumulator having a minimum size $p+q+\log_2 N$ bits. This algorithm has been implemented sequentially in a microprocessor.

The oldest data sample, $X(n-n+1)$ is multiplied by $h(n-1)$ and the result placed in the accumulator. Then the next sample, $X(n-n+2)$, is multiplied by the tap weight $h(n-2)$ and the product is added to the previous product in the accumulator. Thus only a single multiplier and a single accumulator have been needed. The problem with this approach is that a minimum of N sequential multiply-accumulate operations are required between samples. For example, if the sample rate is 1 MHz and the filter length is 256, then the minimum processor clock rate is 256 MHz. A single processor (one containing a single multiplier/accumulator) is limited to less than 1-MHz sample rates, even for short filters.

One solution to the speed problem has been to provide one multiplier/accumulator for each tap. The problem with this structure is that the summing nodes are all cascaded and hence represent a long string of delays in the summing operation. This problem was alleviated by swapping the input and output nodes and reversing the direction of all branches. This form inserts a delay element between each partial sum and the input signal is common to each multiplier. The filter thus consists of N identical modular elements, each consisting of a multiply-add-delay operation. This structure substantially eliminated the propagation time through N adders, but the word width of the adders and delay elements must be equal to or greater than the multiplier product, p+q. If a long filter is to be made up of several cascaded stages of shorter elements, then each delay element and adder must have a width of $p+q+\log_2 N$.

3

For example, a 256-point FIR filter having 8-bit input data and 10-bit filter coefficients requires-adders and delay elements having input word widths of 8+10+8=26 bits. Each multiplier has 8 x 10 with an 18-bit product. The problem with this arrangement is its complexity. For example, a microprocessor such as, for example, a TMS 320 Signal Processor sold by Texas Instruments Incorporated contains a 16 x 16 multiplier and a 32-bit accumulator which occupy approximately 30 percent of the chip area and operate at 5 MHz. Assuming four stages of the filter on a single 50,000-square-mil chip and a sample rate of 5 MHz, then 64 such chips would be required in cascade to implement a 256-point filter. Thus, though faster, this approach is inefficient.

Accordingly it is an object of this invention to provide a FIR digital filter of reduced complexity which provides a speed advantage.

Another object of the invention is to provide a digital filter which restricts the process data values to a minimum number of bit paths.

A further object of the invention is to provide a digital filter capable of operating in a signal processing system in real time.

Yet another object of the invention is to provide a relatively short, high resolution digital filter.

Still another object of the invention is to provide a unique hardware architecture for implementing an FIR digital filter.

Yet, a further object of this invention is to provide a novel digital filter which can be used in any application where existing FIR filters may be used.

Briefly stated this invention comprises a FIR digital filter implemented in hardware using finite fields and the residue number system (RNS); the filter is indistinguishable from a prior art FIR digital filter when observed at the

4

input/output ports. The filter coefficients, hereinafter described in detail, are supplied to the filter in the RNS format. In a digital filter in which the tap weights are fixed, the tap weights are stored in a read only memory (ROM) in RNS form and loaded into the filter at power on. The ROMs bearing the tap weights may be, for example, on chip ROMs. For more versatile filter operations, a set of predetermined tap weights can be stored in ROM and intelligently selected for loading into the filter by a microprocessor. In addition to storing the tap weights in RNS format, the weights can be converted to RNS format by the processor or another decomposition chip can be used to sequentially convert each tap weight before supplying it to the filter. The later method is the fastest and the function can be added to the decomposition/recomposition chip with only a somewhat limited flexibility.

Other objects and features of this invention will become more readily apparent from the following detailed description when read in conjunction with the accompanying drawings, in which:

Figure 1, is a block diagram of a prior art transposed FIR digital filter;

Figure 2, is a simplified block diagram of the finite impulse response (FIR) digital filter implemented using the residue number system (RNS);

Figure 3 is a detailed block diagram of the FIR digital filter of Figure 2;

Figure 4 is a functional block diagram of a RNS finite field adaptable PTF;

Figure 5 is a block diagram of a four ring recomposition chip;

Figure 6a is a block diagram of a modular 5-bit adder;

Figure 6b shows wiring diagrams for headers having different moduli; and

Figure 7 is a block diagram of a ring multiplier.

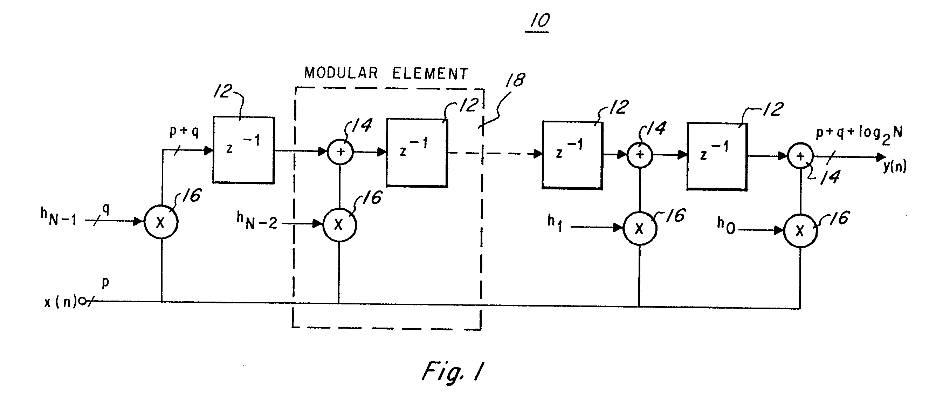

The prior art transposed form FIR filter 10 (Fig. 1) inserts a delay element 12 between each partial sum adder 14 and the input signal X(n) of word width of "p" bits is common to each multiplier 16. The plurality of multipliers 16 are also connected consecutively to the filter coefficients $h_{n-1}$, $h_{n-2}$. . .$h_1$, $h_0$ of word widths of "q" bits. The multipliers output is "p" x "q" product with an output word length of p+q bits. Thus, the filter consists of N identical modular elements 18, each consisting of a multiply-add-delay operation. Hence the propagation time through N adders 14 is eliminated. The word width of the adders and delay elements must be equal to or greater than the multiplier product, "p"+"q". If a long filter is to be made up of several cascaded stages of shorter elements, then each delay element and adder must have a width of "p" + "q" + $\log_2 N$.

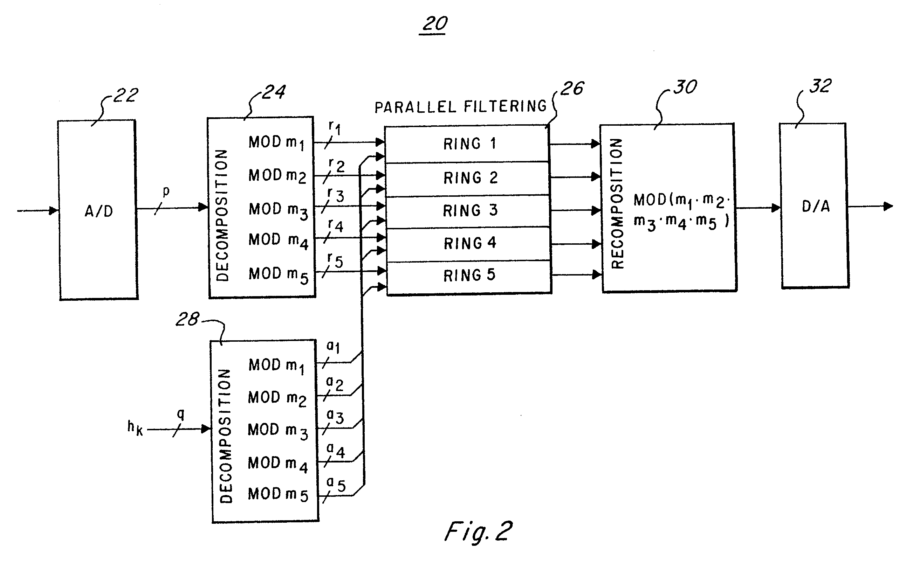

Referring now to Figure 2, implementation of a digital filter in a residue number system is done in three steps. First, the input signal is converted into the residue number system format. Secondly, the RNS signal is filtered. Thirdly, the filtered output is converted back to standard integer (base 10) representation. Thus, the RNS FIR digital filter 20 (Fig. 2) is a five-ring filter. The term "five-ring" filter is used because five "digits" are required to represent a unique value within the filter. Each "digit" is a remainder or residue as a result of dividing the input signal by each modulus, "$m_i$. The operations of addition and multiplication upon each digit constitute a ring for the RNS. Hence five "digits" implies five moduli and thus five rings. The filter coefficients or tap weights are converted to the RNS by dividing each tap weight by the five moduli and using each remainder as an RNS "digit". The widths of both data words and the filter coefficient are only as wide as the number of bits needed to represent $m_i$.

Thus an analog signal is applied to an analog to digital converter (A/DC) 22 which outputs a sequence, X(n), having a word width of "p" bits to a data decomposition means 24

having five modules ($MODm_1$-$MODm_5$). The demodulator 24 divides the input signal by each modulus, $m_i$ and outputs the remainder as digits ($r_1$-$r_5$) to a five ring filter 26.

The filter coefficients or tap weights, $h_k$ of word widths of "q" bits are applied to a data decomposition means 28 where they are divided by the five moduli and the remainders outputted as RNS digits ($a_1$-$a_5$) to the five ring filter 26. The filter convolution is executed in the RNS by the ring filter 26. Each ring output is connected to a data recomposition means 30 which converts the RNS digital word back to a binary word. The data recomposition means 30 is connected to a D/A converter 32 for converting the digital word output of the recomposition means to an analog signal.

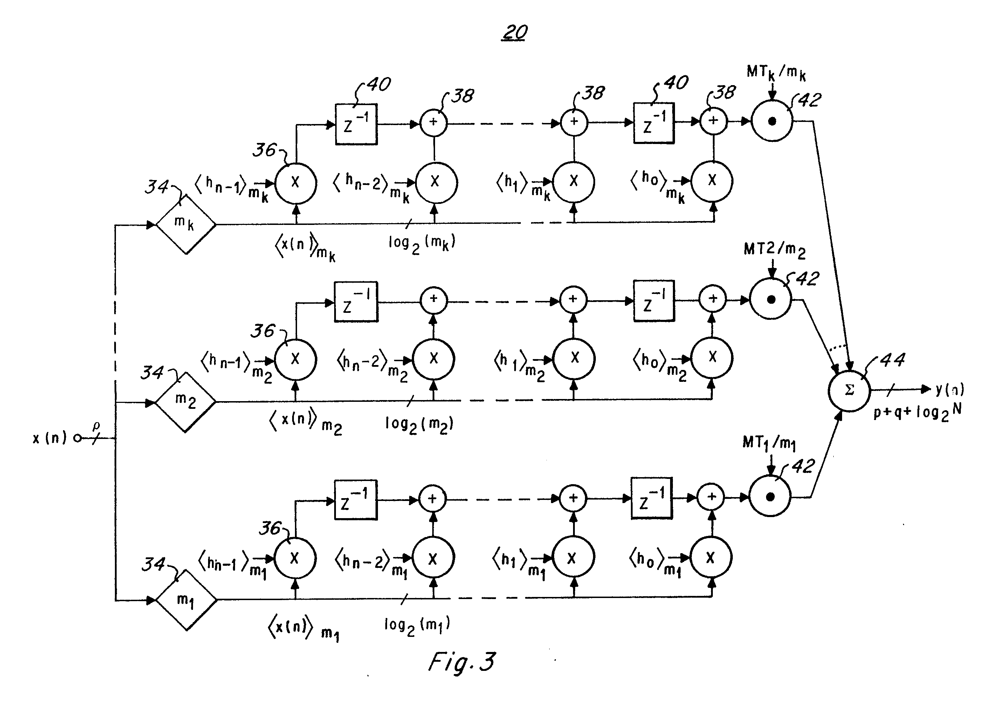

More specifically the RNS FIR digital filter 20 (Fig. 3) has an input data sequence X(n) with word width "p", the filter tap weights $h_j$ with word width "q", and the filter length is N. A set of "K" moduli are selected such that their product is equal to or greater than the maximum value of the output, y(n). The decomposition means 24 (Fig. 2) is represented by a plurality of dividers 34 of which three are shown which are designated $m_1$, $m_2$ and $m_k$ for dividing the digital input by the modulus, $m_i$, and the remainder or residue obtained. The output of each divider 34 is a transformed data sequence, $X(n) > m_i$ or as labeled $<X(n)> m_1$, $<X(n)m_2$ and $<X(n)m_k$ (Fig. 3), which can be considered one "digit" in the RNS. Each filter tap weight is also divided by each modulus, $m_i$, to yield a residue weight, $<h_j>m_i$ labeled $<hn-1>m_1$, $<hn-1>m_2$ and $<hn-1>m_k$ (Fig. 3).

Thus, the filter 26 (Fig. 2) convolution is executed in the RNS. That is each multiplier 36 (Fig. 3) and adder 38 connected as shown with a delay means 40 in between is a modulo multiplier and adder to perform modulo the appropriate value for the ring. All word widths into and out of the multipliers and adders are $\log_2 m_i$ wide.

Finally the recomposition means 30 (Fig. 2) comprises a conventional multiplier 42 (Fig. 3) which multiplies each

ring output, $\langle y(n) \rangle$ $m_i$ by M $T_i/m_i$ and then summing in summer 44. The value of $T_i$ is determined by the relation:

$(M/m_i)T_i \equiv /\text{mod } m_i$

where the products, $MT_i/m_i$, are constant for any given system. Thus, even though multiplicaton by these parameters constitutes a "wide word" multiply, the fact that they are constants can be exploited. Only one "wide-word" summing operation is required.

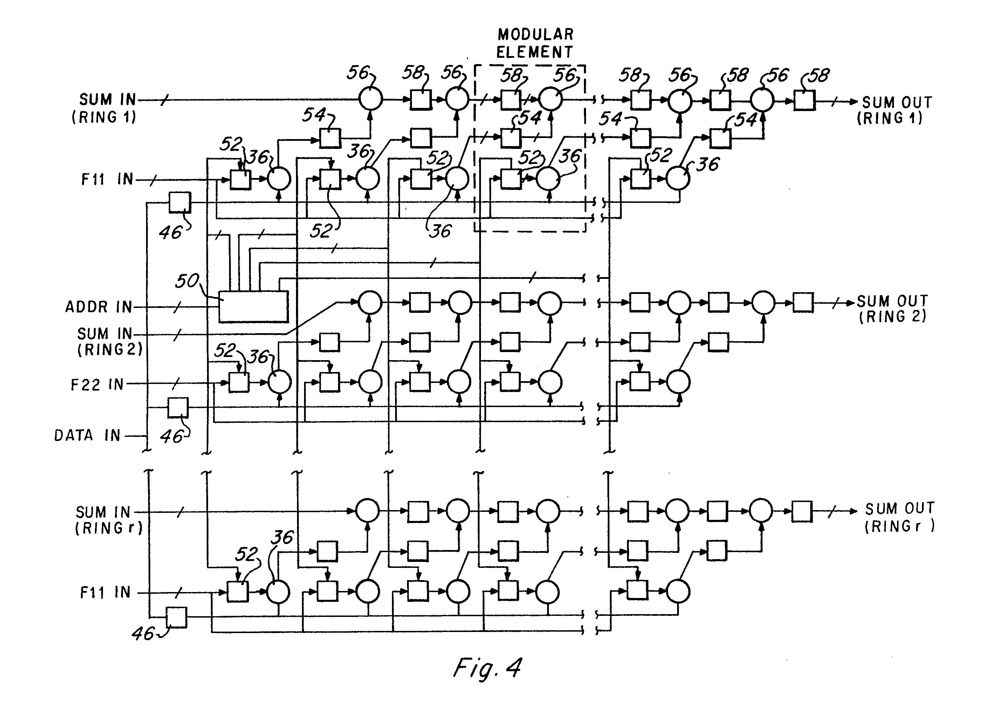

Referring now to Figure 4 for an illustration of how to load a filter tap weight for four rings simultaneously through the use of an address decode for the tap location and five tap weight bits for each ring. The three MOD $M_1$, $M_2$,...$M_n$ blocks 46 represent the decomposition of the A/D converter output (input data stream) to RNS form; they are implemented using 1024 x 5 PROMS as table lookups. The 1024 size allows input data word widths to 10 bits. The RNS outputs from the PROMS (blocks 46) are connected to each modulo multiplier 36. An address decoder 50 is connected to a microprocessor (not shown) and to flip flops 52. Flip-flops 52 are connected to a set of tap weights. The decoder 52 output activates the appropriate flip-flop 52 to selectively couple the tap weight to the modulo multiplier 36. Thus, a filter tap weight is loaded simultaneously into all the rings by virtue of the address decode for the tap location and five tap weight bits for each ring. The modulo output of modulo multipliers 36 are connected to delay means 54 and the delay means 54 are connected to modulo adders 56. A second delay means 58 is connected to the output of each modulo adder 56. Thus, the SUM OUTS from each modular element are cascaded to the SUM INS of the next modular element. The SUM OUTS from the last modular element of each ring are the inputs to the recomposition means 30.

For example in a four mod block the RNS system used may be that based upon the moduli 31, 29, 27 and 25, which provide a product filter modulus of 606825. Thus, the filter provides a 20-bit output, with a true resolution of $\log_2$

8

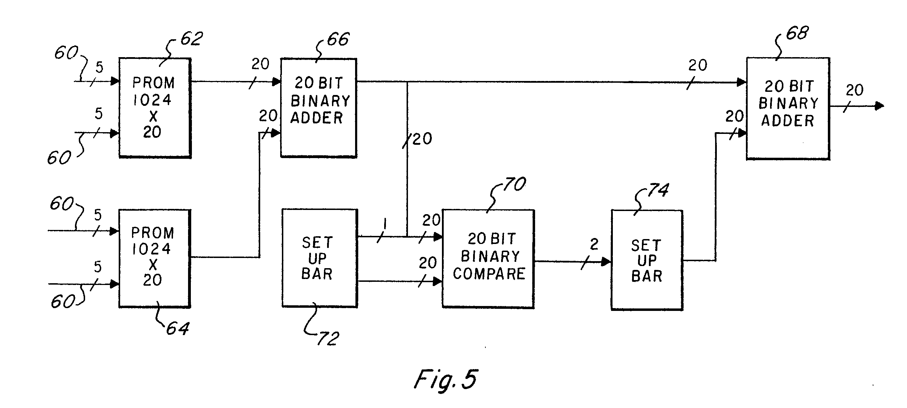

$606825 \approx 19.2$ bits. For this example the recomposition means 30 (Fig. 5) is a combination of "lookup" and Chinese remainder theorem recomposition. The large multiples functionally necessary for the recomposition are avoided by looking up two partial recomposition terms; this is made possible as once the RNS moduli have been selected the recomposition transform coefficients are fixed constants.

The 5-bit SUM OUT values of output leads 60 (Fig.s 4 & 5) are connected to two PROMS 62 and 64 whose outputs must still be combined modulo 606825 addition to produce the final output. To do this the PROMS 62 and 64 are connected to a 20 bit binary adder 66. Binary adder 66 has its output, selectively, connected, respectively, to 20 bit adder 68, comparator 70 and set up bar 72. Set up bar 72 has its output connected to comparator 70 and comparator 70 has its output connected to set up bar 74. Set up bar 74 has its output connected to the adder 68. The binary 66 and 68 and comparator 70 perform the modulo 606825 addition to produce the final output. The two set up bars 72 and 74 operate to connect through the appropriate sense of the sign bit to allow the modulus 606825 or its 20 bit complement, 441751, to be applied in correcting the regular 20-bit binary output of the first adder 62 to provide a 20-bit 2's complement output modulo 606825 from the second adder 68. Overflow, underflow, and correct scaling of the 2's complement output are accounted for by this implementation.

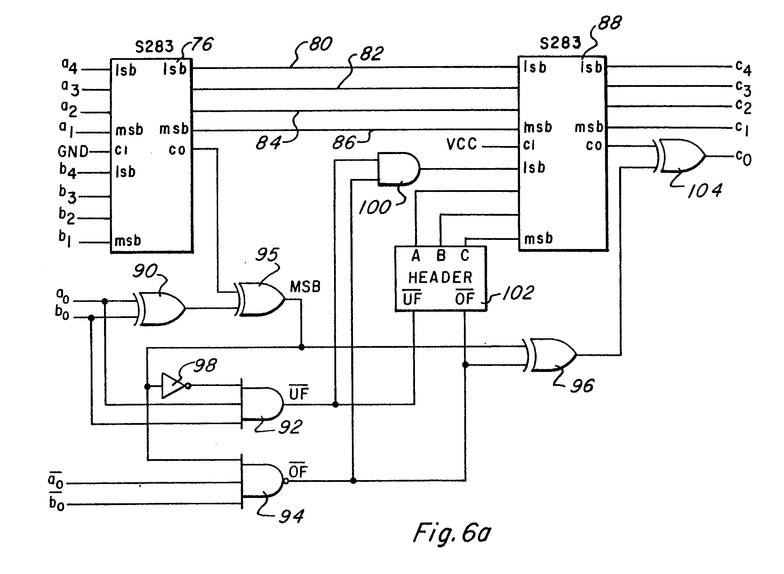

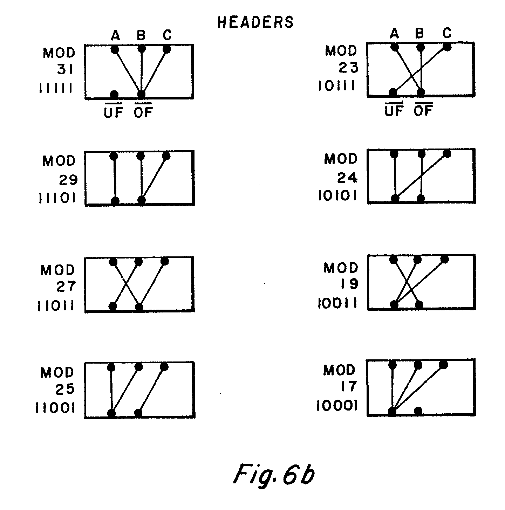

Referring now to Fig. 6a for a description of a generic modulo adder, a four bit adder 76 is connected to receive 2's complement numbers at terminals $a_1$-$a_4$ and $b_1$-$b_4$ and the binary sum thereof output on leads 80 and 86 to four bit adder 88. The four bit adders 76 and 88 are S283 four bit adders sold by Texas Instruments Incorporated. The fifth or sign bit is accomodated as follows. The sign bit $a_0$, $b_0$ is connected to exclusive OR gate and NAND gate 92 and its 2's complement $\bar{a}_0$, $\bar{b}_0$ is connected to NAND gate 94.

0166563

9

Exclusive OR gate 90 has its output connected to a first terminal of exclusive OR gate 95 ; exclusive OR gate has a second input terminal connected to the carry over (CO) terminal of adder 76. The most significant bit (MSB) output of exclusive OR gate 95 is connected, respectively, to an exclusive OR gate 96, NAND gate 92 through an inverter 98, and NAND gate 94. NAND gate 92 has its $\overline{UF}$ (underflow) output connected, respectively, to AND gate 100 and header 102; whilst NAND gate 94 has its $\overline{OF}$ (overflow) output connected, respectively, to AND gate 100, exclusive OR gate 96 and header 102. AND gate 100 has its output connected to the LSB (lease significant bit) terminal of adder 88, header 102 has its A, B, C outputs connected to the adder 88 and exclusive OR gate 96 has its output connected to exclusive OR gate 104. Finally adder 88 provides its modulo output on terminals C4-C1 and the carry over (CO) status at the CO terminal is connected to exclusive OR gate 104. The CO output of exclusive OR gate 104 indicates the sign of the output of adder 88.

Adder 76 forms a regular binary sum and if the sum is out of range of the 2's complement modulo representation needed for the output the second binary adder 88 fixes it up. The output of the second binary adder may still be any possible combination of the five output bits. Adder 88 works on a modulo wraparound representation; so that two different outputs may correspond to the same modulo number. This feature allows nearly complete parallelism between the adders of the different rings. The only change needed to alter the modulus of the adder is to alter the connections of the headers as shown in Figure 6b.

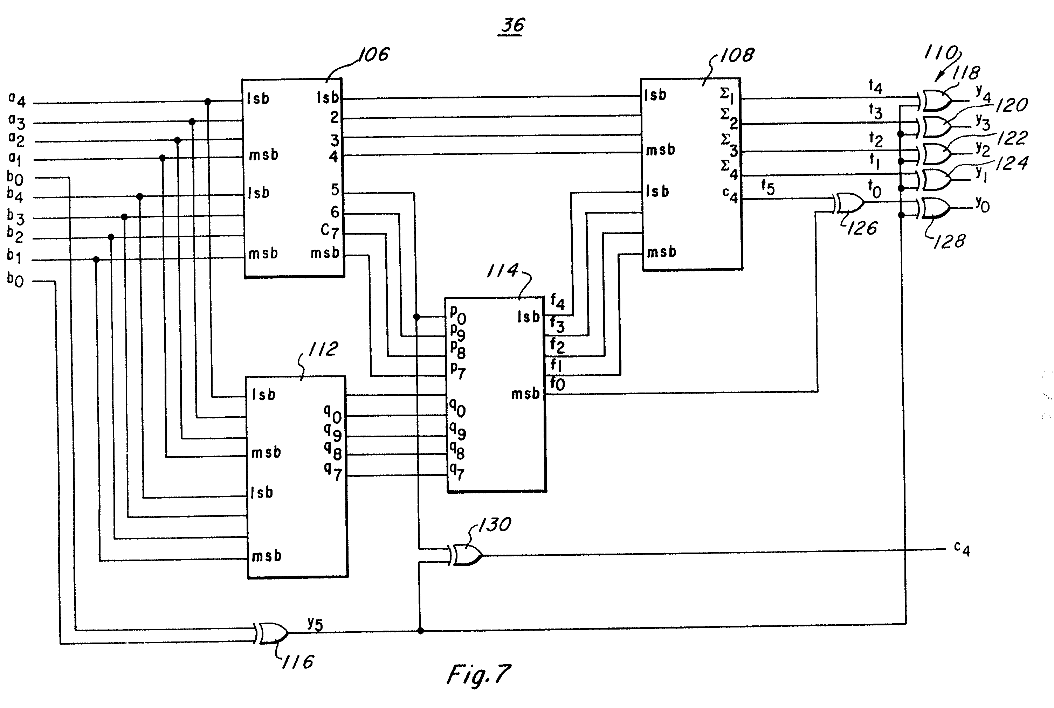

Referring now to Figure 7, the modulo multiplier 36 comprises a 4x4 multiplier 106, a 4x4 adder 108, 8 exclusive-OR gates 110, "overflow detector" 112, and a "modulo fix-up" gate device 114. The multiplier 106, adder 108 and 8 exclusive OR gates are standard TTL chips sold by Texas Instruments Incorporated under the designations

10

SN54LS274, SN54LS283 and two SN54LS86's (each having 4 exclusive OR's), respectively. The overflow detector 112 and the fix-up gate device each includes a plurality of 3 delay level AND and OR gates.

The multiplier 106 and the overflow detector 112 have their input terminals $a_1$-$a_4$ and $b_1$-$b_4$ connected to receive the magnitude bits of the modulus numbers. An exclusive OR gate 116 of exclusive OR gates 110 is connected to receive the modulo sign bits.

The binary multiplier 106 has its output terminals $p_1$-$p_4$ connected to corresponding input terminals ($a_1$-$a_4$) of the binary adder for inputting the least significant magnitude bits and its output terminals $p_0$, and $p_7$-$p_9$ connected to corresponding input terminals of the modulo fix-up device. The overflow detector 112 has its output terminals $q_7$-$q_9$ and $q_0$ and outut terminals connected to corresponding input terminals of the modulo fix-up device 114. The modulo fix-up device 114 combines the most significant bits (overflow) outputs of the multiplier and any detected overflow of the modulo fix-up device and outputs on output terminals $f_0$-$f_4$ the combined overflow to corresponding terminals ($b_1$-$b_4$) of the binary adder 108.

Adder 108 sums the least significant outputs of the binary multiplier 106 and the least significant bits of the modulo fixup device 114 and outputs on output terminals $\Sigma_1$-$\Sigma_4$ and $c_4$ (carry out) to exclusive OR gates 118, 120, 122, 124 and 126 of OR gates 110. Exclusive OR gate 126 has a second input terminal connected to the most significant bit (sign bit) of the modulo fixup device 114 and its output terminal connected to exclusive OR gate 128.

Exclusive OR gate 116 compares the two original modulo sign bits and outputs a sign indicating signal to an exclusive OR gate 130 and exclusive OR gates 118, 120, 122, 124, and 128. Exclusive OR gate 130 is also connected to sign indicating terminal $p_0$ of the multiplier 106 and outputs a carry over for a 2's complement representation of the final output of the exclusive OR gates 118, 120, 122, 124 and 128.

The implementation of Figure 7 mixes data modes required on input and output to reduce gate count required for the multiply function. The input data words described by $a_0$, $a_1$, $a_2$, $a_3$, $a_4$ and $b_0$, $b_1$, $b_2$, $b_3$, $b_4$ are expressed in sign and magnitude form. That is, $a_0$ and $b_0$ are sign bits while the magnitude of each component is specified in standard binary form by the remaining 4 bits of that component. This allows the use of the 4x4 multiply (70 gates) instead of a 5x5 multiply (126 gates) in the implementation. The output is expressed in 2's complement notation by the use of the 7 exclusive OR gates. The exclusive OR of the sign bits $a_0$ and $b_0$ determines the need to invert the combination of $t_0$, $t_1$, $t_2$, $t_3$, $t_4$ and $y_5$. The 5-bit word $t_0$, $t_1$, $t_2$, $t_3$, $t_4$, $t_5$ is a 1's complement result and together with the carry bit, $y_5$, form the 2's complement result of the 4x4 modulo multiplication of the magnitude bits $a_1$, $a_2$, $a_3$, $a_4$ x $b_1$, $b_2$, $b_3$, $b_4$. The final result is determined by the 6 bits $y_0$, $y_1$, $y_2$, $y_3$, $y_4$ (1's complement component) and $c_4$ (carry-in for 2's complement representation).

The 1's complement value $t_0$, $t_1$, $t_2$, $t_3$, $t_4$ is a unique representation that is specified by the input magnitudes and the modulus of the multiply. The adder 108 is extended from a 4x4 to a 4x5 adder by the use of the exclusive OR gate 126 that produces $t_0$ as its output. This 4x5 adder need not account for the possibility of carryout, overflow, or underflow, these factors being pre-accounted for, in the determination of the 5-bit fix-up of the fix-up device 114 to the 4x5 adder 108. The fix up output, $f_0$, $f_1$, $f_2$, $f_3$, $f_4$, is the binary representation that correctly produces $t_0$, $t_1$, $t_2$, $t_3$, $t_4$. Dependence on $a_0$ and $b_0$ is avoided by the use of the carry bit, $y_5$, to post convert to 2's complement representation. This requirement imposes the need for an extra storage bit to pass the carryout, $c_4$, along with $y_0$, $y_1$, $y_2$, $y_3$, $y_4$ to the modulo adder (Fig. 6a) which then uses

12

it as a carry-in to the first adder 76 of its two 4x4 adders.

The input magnitude bits $a_1$, $a_2$, $a_3$, $a_4$ and $b_1$, $b_2$, $b_3$, $b_4$, (Fig. 7) are inputs to the multiplier 106 and the overflow detector 112. The least significant output bits from the multiplier 106 are correct if there is no overflow in the modulo multiply. That is, the bits $p_0$, $p_1$, $p_2$, $p_3$, $p_4$ provide the 5-bit modulo magnitude of the multiply while the bits $p_7$, $p_8$, $p_9$ as well as $p_0$ are overflow bits. $p_0$ changes roles from a magnitude bit to a sign sense bit due to the mixed data modes used on input and output. When the overflow detector outputs and $p_7$, $p_8$, $p_9$ are all logic zero, then $p_0$ is passed directly to $f_0$ by the fix-up reduction, and the sign bit output $t_0$ is equal to $p_0$ since $t_5$ is forced to be zero in this case. Mod 31 stands out as a special case here, needing no fix-up reduction section since each of the bits $p_7$, $p_8$, $p_9$ can be passed directly to $f_2$, $f_3$, $f_4$ while $f_1$ will always be zero. Also all overflow detector outputs are accounted for by using the carry-in port, $c_0$, of the adder 108. The overflow detector outputs $q_7$, $q_8$, $q_9$, $q_0$ are constructed to provide, after their or-ing with $p_7$, $p_8$, $p_9$, $p_0$, respectively, a 4-bit code $d_7$, $d_8$, $d_9$, $d_0$. This code has then been minimized by 2-level logic reduction for each odd moduli of 5-bit width (17, 19, 21, 23, 25, 27, 29) producing the 5 bit fixup $f_0$, $f_1$, $f_2$, $f_3$, $f_4$. Exceptions noted are that mod 17 and mod 19 need only a 3-bit code $d_8$, $d_9$, $d_0$.

The overflow squared is needed because of the possibility that the sum of the fix-up $f_0$, $f_1$, $f_2$, $f_3$, $f_4$ with $p_1$, $p_2$, $p_3$, $p_4$ will again result in another overflow occurring which if not predetected would then require another adder and the associated delay to produce the final output. Thus the function of the overflow detector is to detect those combinations of the inputs $a_1$, $a_2$, $a_3$, $a_4$ and $b_1$, $b_2$, $b_3$, $b_4$ which cause this condition and then appropriately alter the 4-bit code $d_7$, $d_8$, $d_9$, $d_0$ to either produce a new code for this combination or alter the code to that code which has the

13

same fix-up ($f_0$, $f_1$, $f_2$, $f_3$, $f_4$) requirement.

The equivalence of RNS and regular number systems (for numbers less than the product modulus) is established by the number theory result known as the Chinese remainder theorem. The problem is that of solving a set of simultaneous linear congruences with different moduli for a digital filter using the formula:

$$A = X_i \text{ modulo } m_i \quad i=1, \ldots, r$$

A represents the integer output of the digital filter. The number of rings in the RNS is r, and $X_i$ is the value of the rth place in the RNS representation of the number.

The Chinese remainder theorem states that this problem has a unique solution modulo M, whenever the $m_i$ are relatively prime in pairs. This uniqueness leads to the equivalence mentioned above.

The proof of the theorem is established by discovering how to solve the problem. The solution to the problem is in the relation

$$A = \sum_{i=1}^{r} (MT_i)/(m_i) \; x_i \text{ modulo } M$$

where: $(MT_i)/(m_i) \equiv 1 \text{ modulo } m_i$

and

$$M = \prod_{i=1}^{r} m_i$$

The coefficients $(MT_i)/(m_i)$ are the recomposition coefficients needed. The requirement $(MT_i)/(m_i) \equiv 1$ modulo $m_i$ corresponds to the RNS "digits" being incremented at every count of the RNS odometer (illustrated in Table 1). But this requirement is met only when $M/m_i$ and $m_i$ are relatively prime. When $M/m_i$ and $m_i$ are relatively prime, the multiples of $M/m_i$ taken modulo $m_i$ form a permutation of the elements of the ring of integers modulo $m_i$. To see

14

this, consider two multiples, a $(M/m_i)$ and $b(M/m_i)$ where a $\overset{\neq}{=}$ b mod $m_i$. If a $(M/m_i) \equiv b(M/m_i)$ mod$m_i$; then $m_i$ must divide $(a-b) \cdot (M/m_i)$. But this implies $m_i$ divides $(a-b)$, as no factor of $m_i$ can divide $M/m_i$. But then the contradiction a$\equiv$b mod $m_i$ follows, therefore, the multiples cannot be the same, and thus the ring can be permuted. Finally as any ring has a unit element there must then be a multiple $T_i$ of $M/m_i$ such that $(M/m_i)T_i \equiv 1$ mod$m_i$. This permutatin relationship allows us to see that each $T_i$ is merely a transform operator that governs the relationship between two ways of expressing the set of integers mod $M_i$ the standard way and the RNS representation based upon the factorization:

$$M = \overset{r}{\underset{i=1}{\pi}}\ m_i$$

Having now determined the existance of the recomposition coefficients it remains to be shown that

$$A \equiv \overset{r}{\underset{i=1}{\Sigma}}\ (MT_i)/(m_i)\ X_i \text{ modulo } M$$

does satisfy $A \equiv X_i$ modulo $M_i$ for i=1, ...r. This is done for any of the i by reducing the modulo M equation to a modulo $m_i$ equation,

$$A \equiv \overset{r}{\underset{i \neq 1}{\Sigma}}(MT_j)/(m_j)\ X_i \text{ modulo } m_i$$

For i $\neq$ j, $m_i$ divides $M/m_j$ and therefore all terms except the ith term vanish from the equation, vis $A \equiv (MT_i)/(m_i)\ X_i$ modulo $m_i$. However, $(MT_i/(m_i) \equiv 1$ modulo $m_i$, and therefore $A \equiv X_i$ modulo $m_i$ for i=1, ..., r, as is required to solve the original problem.

Having established by the Chinese remainder theorem that for every integer less than some large composite integer M, there exists a unique equivalent representation in the RNS based upon the factorization of M, it is next necessary to establish that operations exist in the RNS which are equivalent to the usual operations of addition and multiplication for integers. To do this it must be shown that for any integers $K_1$ and $K_2$ and for the transformation devoted by T the RNS elements are $K_1T$ and $K_2T$ that $(K_1+K_2)T = K_1T \oplus K_2T$ and $(K_1K_2)T = K_1T \odot K_2T$, where $+, \cdot$ are regular operations and $\oplus \odot$ are the corresponding operations in an RNS representation.

As the argument for $\odot$ is identical to the argument for $\oplus$ only the $\oplus$ argument is presented. Assuming A+B=C modulo M, it must be shown that AT+BT=(C modulo M)T=(A+B)T.

Let $X_1X_2...X_r$ and $Y_1Y_2...Y_r$ be the RNS representations.

Then

$AT=X_1X_2...X_r$ where $A \equiv X_i$ mod $m_i, i \equiv 1 ..., r$

and

$BT=Y_1Y_2...Y_r$ where $B \equiv Y_i$ mod $m_i, i \equiv 1, ..., r$

Thus

$AT \oplus BT = X_1X_2...X_r \oplus Y_1Y_2...Y_r$

$= <X_1+Y_1>1<X_2+Y_2>2... X_r+Y_r>r$

where $<\cdot>_i$ indicates mod $m_i$, but

$A+B \equiv (X_i+Y_i)$ mod$_i$, $i=1,...,r$, by the congruences above,

so

$AT \oplus BT=(A+B)T$

Having demonstrated the isomorphism between the RNS decomposition based on $M=M_1, ..., M_r$ and the integers modulo M we may further elucidite that we have decomposed the ring of integers mod M into the direct sum of its subrings, these being the rings of integers mod $m_i$, $i=1, ..., r$. Direct sum here means that any element of the ring mod M can be realized as a linear combination of the subring elements, VIS: the Chinese remainder theorem recomposition formula. If the $M_i$ are prime, then the decompositon is complete and the subrings

16

are subfields; any finite ring can be so decomposed. Two simple problem examples will demonstrate the RNS. The first is the measurement of angles. Angles are measured modulo 360, i.e., an angle of 365 degrees is congruent with (undistinguishable from) an angle of 5 degrees. Two integers $a_1$ and $a_2$ are said to be congruent mod b if divides the difference $(a_1-a_2)$ $\left(\dfrac{365-5}{360}=1\right)$ and this congruence or equivalence is denoted by:

$a_1 \equiv a_2$ mod b

Any integer can be expressed in terms of quotients and remainders, i.e.,

a=bq+r

where a is any integer, b is the modulus, q is the quotient and r is the remainder for a/b. The remainder r is called the residue of a mod b, i.e.

$r \equiv a$ mod b

In this example there are only 360 unique integer angular values which can be represented in degrees. However, it is possible to extend the range of integers which can be represented by using groups of RSNs, each having a different modulus. The problem is how to select the modulus.

The Chinese remainder theorem is used to select the moduli and to provide a way of converting numbers represented in the RNS to conventional integers. The theorem is as follows: Let $m_i$ be k positive integers greater than one and relatively prime in pairs. The set of linear congruences $X=r_i$ mod$m_i$ has a unique solution mod M where:

$$M = \prod_{i=2}^{k} m_i$$

Thus the condition on selecting the moduli for the digits of the RNS is that they must be greater than unity and they must be relatively prime in pairs. The definition of "relatively prime in pairs" is that all pair combinations must have only unity as their greatest common divisior (GCD). For example consider the numbers 4, 5, and 6. The GCD (4, 5)

17

= 1 as is GCD (5, 6). But, GCD (4, 6) = 2; hence the integers 4, 5 and 6 are not relatively prime. However, the numbers 4, 5 and 7 are relatively prime. GCD (4, 7) = 1 and GCD (5, 7) = 1. The number 4 is not a prime number, but this does not matter.

The composite modulus, M, which determines the number of unique integers which can be represented by the three moduli (4, 5 and 7) is simply their product: $4 \cdot 5 \cdot 7 = 140$.

The second problem is to translate from an RNS dial reading to a standard integer representation using the Chinese remainder theorem. Assuming an odometer which used integers 3, 5, 7 (reading right to left) as moduli for three dials. The dials read 502. Let X be the conventional integer representation for the mileage reading of the odometer. Let $r_3$, $r_5$ and $r_7$ be the integer readings, respectively, for the mod 3, mod 5 and mod 7 dials and let T be a variable for a parameter.

Then:

$$X \equiv [(3 \cdot 5 \cdot 7/3) r_3 T_3 + (3 \cdot 5 \cdot 7/5) r_5 T_5 + (3 \cdot 5 \cdot 7/7) r_7 T_7] \bmod 105$$

where

$$(3 \cdot 5 \cdot 7/3) T_3 \equiv 1 \bmod 3$$
$$(3 \cdot 5 \cdot 7/5) T_5 \equiv 1 \bmod 5$$
$$(3 \cdot 5 \cdot 7/7) T_7 \equiv 1 \bmod 7$$

To convert the dial reading of 502, first solve for $T_3$, $T_5$ and $T_7$:

$35 T_3 \equiv 1 \bmod 3$ and $T_3$ (by trial and error) = 2
Try 1: (35)(1)/3=11 r2 (NO GOOD); Try 2: (35)(2)/3=23 r1 (GOOD) Thus $T_3 = 2$

$21 T_5 \equiv 1 \bmod 5$ and $T_5 = 1$
$15 T_7 \equiv 1 \bmod 7$ and $T_7 = 1$

Then the mileage indicated, X, is:

$$X \equiv [(35)(2)(2) + (21)(1)(0) + (15)(1)(5)] \bmod 105$$
$$\equiv (140 + 0 + 75) \bmod 105; \quad 215/105 = 2 r_5$$
$$\equiv 5 \bmod 105$$

Hence in this system, an odometer reading of 502 indicates that 5 miles have been traveled. The dial is good for measuring mileage increments 1 to 105.

18

The algorithm can be generalized as follows:

$$X \equiv \sum_{i=1}^{k} (M/m_i) r_i T_i \text{ modulo } M$$

$$(M/m_i) T_i \equiv 1 \text{ modulo } m_i$$

$$M = \pi_{i=1}^{k} m_i$$

This is the basis for defining the structure to be used in the finite field filter as well as the procedure for extracting meaningful information from the filter output.

Although a single embodiment of the invention has been described, it will be apparent to a person skilled in the art that various modifications to the details of construction shown and described can be made without departing from the scope of this invention.

CLAIMS

1. A residue number system universal filter system comprising:

a) an A/D converter for converting an analog signal to a digital signal in a first format;

b) a decomposition means operatively connected to the A/D converter for changing the first format of the digital signal to a second format;

c) a filter means operatively connected to the decomposition means for filtering the input signal in the second format;

d) a recomposition means operatively connected to the filter means for converting the filtered output signal from the second format to the first format; and

e) a D/A converter for converting the output signal from the first digital format to an analog signal.

2. A residue number system digital universal filter system comprising:

a) a decomposition means for converting an input signal in a first digital format into a second format;

b) a filter means for filtering the input signal in the second format; and

c) a recomposition means operatively connected to the filter means for converting the filtered signal from the second format to the first digital format.

3. A residue number system digital universal filter system according to claim 2 further including an analog to digital converter operatively connected to the decomposition means for converting analog signals to signals in a first digital format.

0166563

20

4. A residue number system digital universal filter system according to claim 3 further including a digital to analog converter operatively connected to the decomposition means for converting signals in a first digital format to analog signals.

5. A residue number system digital universal filter system according to claim 2 wherein the signals in the first digital format are digital binary signals and the decomposition means comprises conversion means for converting the digital binary signals to residue number system digital signals as the second digital format.

6. A residue number system digital universal filter system according to claim 5 wherein the recomposition means comprises conversion means for converting the residue number system digital signals to digital binary signals.

7. A residue number system digital universal filter system according to claim 6 wherein the conversion means is a read only memory.

8. A residue number system digital universal filter system according to claim 6 wherein the conversion means is a combination of a read only memory and an adder.

9. A residue number system digital universal filter system according to claim 6 wherein the comparison means is a combination of a read only memory, adder and a comparator.

10. A residue number system digital universal filter system according to claim 2 wherein the decomposition means comprises a plurality of digital divider means for dividing input signals in the first digital format by a preselected modulus for obtaining remainders representative of digits in (Claim 10 Continued)
the RNS, a source of filter tap weights, divider means operatively connected to the source of filter tap weights for dividing the filter tap weight by a preselected modulus to produce a residue tap weight in the RNS, and an address means for selectively outputting the RNS tap weights to the filter means.

11. A residue number system digital universal filter system according to claim 10 wherein the source of filter tap weights includes a programmable read only memory.

12. A residue number system digital universal filter system according to claim 2 wherein the filter means for performing filter convolution comprises a plurality of modular elements, each modular element including an RNS multiplier means, an RNS adder means, and a delay means, said RNS multiplier means operatively connected to the decomposition means for multiplying the digit in the RNS of the corresponding digital divider by a preselected tap weight in the RNS, said adder means operatively connected to a delay means of a preceding modular element and to the multiplier for adding the Sum-In Output of the preceding modular element to the RNS product of the multiplier, and said delay means operatively connected to the adder whereby the propagation time through the adders of the plurality of modular elements is substantially eliminated.

13. A residue number system digital universal filter system according to claim 2 wherein the recomposition means includes a plurality of multipliers for multiplying the RNS outputs of the filter by recomposition coefficients and an adding means operatively connected to the plurality of

(Claim 13 Continued)                22

multipliers for summing to provide a digital convolution of a filter function.

14. A residue number system universal digital filter system comprising:

a) storage means for storing preselected numbers in the residue number system;

b) a decoder means for decoding preselected addresses for locations in the storage means;

c) a plurality of storage registers operatively connected to the storage means and address decoder for storing a plurality of tap weights associated with the addresses of the plurality of storage registers;

d) a decomposition means comprising a plurality of dividers for dividing binary input signals by preselected modulus;

e) a digital filter having a preselected number of taps, said digital filter including a plurality of rings each having a preselected bit width and a plurality of modular elements operatively connected in cascade said plurality of decomposition means and storage registers operative in response to the address decode for the tap location and preselected number of tap-weight bits for each ring to load the plurality of filter rings simultaneously and the SUM OUTS from each modular element cascaded to the SUM INS of the next modular element; and

f) a recomposition means operatively connected to the last modular elements of the plurality of rings for receiving their SUM OUTS.

Fig. 1

Fig. 2

Fig.3

20

$x(n)$

$y(n)$

$p+q+\log_2 N$

$\Sigma$ — 44

$MT_k/m_k$ — 42
$MT2/m_2$ — 42
$MT_1/m_1$ — 42

38 40

$Z^{-1}$

$\langle h_0 \rangle_{m_k}$ $\langle h_1 \rangle_{m_k}$ $\langle h_{n-2} \rangle_{m_k}$ $\langle h_{n-1} \rangle_{m_k}$ $\langle x(n) \rangle_{m_k}$ $\log_2(m_k)$ $m_k$ — 34, 36

$\langle h_0 \rangle_{m_2}$ $\langle h_1 \rangle_{m_2}$ $\langle h_{n-2} \rangle_{m_2}$ $\langle h_{n-1} \rangle_{m_2}$ $\langle x(n) \rangle_{m_2}$ $\log_2(m_2)$ $m_2$ — 34, 36

$\langle h_0 \rangle_{m_1}$ $\langle h_1 \rangle_{m_1}$ $\langle h_{n-2} \rangle_{m_1}$ $\langle h_{n-1} \rangle_{m_1}$ $\langle x(n) \rangle_{m_1}$ $\log_2(m_1)$ $m_1$ — 34, 36

MODULAR ELEMENT

SUM OUT (RING 1)

SUM OUT (RING 2)

SUM OUT (RING r )

SUM IN (RING 1)

F11 IN

ADDR IN

SUM IN (RING 2)

F22 IN

DATA IN

SUM IN (RING r)

F11 IN

58 56 58 56 58 54 52 36

50 46

Fig. 4

Fig. 5

Fig.6a

HEADERS

Fig. 6b

Fig.7